# EUROPEAN PATENT SPECIFICATION

(11) **EP 3 734 692 B1**
(45) Date of publication and mention of the grant of the patent: **25.08.2021**
(21) Application number: 19211070.8
(22) Date of filing: 22.11.2019
(51) Int. Cl.: H01M 10/42, H01M 10/48, H01M 50/581, H01M 50/204, H01M 50/375, G01R 31/392, H01M 50/30

(54) **BATTERY MODULE AND BATTERY PACK**
BATTERIEMODUL UND BATTERIEPACK
MODULE DE BATTERIE ET BLOC BATTERIE

(30) Priority: 30.04.2019 CN 201920620796 U
(43) Date of publication of application: 04.11.2020
(73) Proprietor: Contemporary Amperex Technology Co., Limited, Jiaocheng District Ningde City Fujian 352100 (CN)
(72) Inventor: ZHU,, Xianchun, Ningde City, Fujian 352100 (CN); ZENG,, Chao, Ningde City, Fujian 352100 (CN); CAO,, Hua, Ningde City, Fujian 352100 (CN); WANG,, Chong, Ningde City, Fujian 352100 (CN)
(74) Representative: Grey, Ian Michael

(56) References cited:
- JP-A- 2005 346 943
- JP-A- 2008 251 470
- JP-A- 2014 160 573

## Description

### TECHNICAL FIELD

The present disclosure relates to a technical filed of batteries, and particularly relates to a battery module and a battery pack.

### BACKGROUND

As energy densities of a power battery and an energy storage battery increase, requirements on safety of the batteries become higher and higher. In a battery pack, a thermal runaway of a battery cell may occur when the battery cell is misused. When the thermal runaway occurs, a high temperature and fire may be formed quickly, which may bring great damage, and easily cause a great safety accident.

In the existing module design of the power battery and the energy storage battery, merely voltages and temperature signals of some of the battery cells are collected and transmitted for sampling of the battery cells, which cannot effectively and accurately provide and transmit a prompt signal indicating the thermal runaway of the battery cell, to the outside.

Document JP 2014 160 573 A discloses a power storage device, which houses a plurality of lithium ion batteries each with a safety valve in a container formed of a container body and a container cover. A recovery portion which recovers an electrolyte ejected due to activation of the safety valve is provided mutually opposed to the safety valve of each of the plurality of lithium ion batteries. The recovery portion is a recovering space having a sealed structure partitioned by a division wall mutually opposed to the safety valve of each lithium ion battery, a recovering port is opened at a division wall position mutually opposed to the safety valve, and the fire of the electrolyte ejected due to thermal runaway of the lithium ion batteries thereby is prevented from diffusing into the container.

### SUMMARY

The embodiments of the present disclosure disclose a battery module and a battery pack, which can provide a signal indicating a thermal runaway of a battery cell.

On one aspect, the embodiments of the present disclosure discloses a battery module, including: a battery assembly, including a plurality of battery cells arranged in an array, wherein each of the battery cells includes a vent; a circuit board, including a plurality of sampling terminals connected to the battery cells and being capable of collecting electrical parameters and/or temperature parameters of the battery cells; and a thermal cable, located between the battery assembly and the circuit board and fixedly coupled to the circuit board, wherein a thermal circuit is formed inside the thermal cable, and the thermal circuit can provide a prompt signal indicating a bursting of the vent of any of the battery cells, wherein the battery module further includes a cover block, extending in a first direction and provided with at least an accommodating portion penetrating the cover block in the first direction, wherein the thermal cable is at least partially accommodated in the accommodating portion, and the cover block is coupled to the circuit board.

According to one aspect of the embodiments of the present disclosure, the thermal cable includes a wire forming the thermal circuit and an insulating layer surrounding an outer periphery of the wire, and the insulating layer of the thermal cable is melted when the vent of any of the battery cells bursts, so as to short-circuit the thermal circuit and provide the prompt signal.

According to one aspect of the embodiments of the present disclosure, the battery module further includes a connecting member, including an abutting portion and a clamping portion connected with each other; and the circuit board includes a first surface facing away from the battery assembly and a second surface facing the battery assembly, and the circuit board is provided with a hole penetrating the first surface and the second surface, wherein the abutting portion is configured to abut against the first surface, and the clamping portion is configured to pass through the hole and clamp the cover block.

According to one aspect of the embodiments of the present disclosure, the abutting portion includes a third surface facing the circuit board, and the clamping portion includes a first protrusion and a second protrusion protruding from the third surface, wherein the first protrusion and the second protrusion are spaced apart from each other with a clamping space formed between them, and the cover block is located in the clamping space; and the cover block is configured to abut against the second surface of the circuit board.

According to one aspect of the embodiments of the present disclosure, the abutting portion has a fourth surface facing away from the circuit board, and is provided with a recess on the third surface, wherein the recess is recessed toward the fourth surface of the abutting portion and is capable of accommodating a portion of the circuit board.

According to one aspect of the embodiments of the present disclosure, each of the battery cells includes an electrode, and the battery module further includes a busbar for connecting the electrodes of the battery cells, and the sampling terminals of the circuit board are connected to the battery cells via the busbar; and the abutting portion is configured to extend in a second direction, which intersects with the first direction, and has two end portions opposite to each other in the second direction, wherein each of the two end portions is provided with a snap member on the third surface, and the snap member can be coupled to the battery cell and/or the busbar in a snap fit manner.

According to one aspect of the embodiments of the present disclosure, the snap member includes a snap groove, which is engaged with the battery cell and/or the busbar in a snap fit manner and includes a snap surface abutting against the battery cell and/or the busbar, wherein a distance of the snap surface to the second surface of the circuit board is smaller than a thickness of the cover block.

According to one aspect of the embodiments of the present disclosure, the accommodating portion is formed as a channel extending in the first direction, and the cover block has a fifth surface facing the circuit board, wherein the channel is provided with an opening located at the fifth surface and has an inner wall surface in a shape matching with a shape of an outer peripheral surface of the thermal cable.

According to one aspect of the embodiments of the present disclosure, the thermal cable is interference-fitted with the accommodating portion.

According to one aspect of the embodiments of the present disclosure, the cover block is formed as an elastic block.

According to one aspect of the embodiments of the present disclosure, the thermal cable has a projection passing through the vents of the plurality of battery cells, on a plane where the vents of the plurality of battery cells are located.

On a further aspect, the embodiments of the present disclosure discloses a battery pack, including a battery module according to any of the above embodiments and a battery management system module, wherein the thermal cable of the battery module is electrically connected to the battery management system module.

On a further aspect, the embodiments of the present disclosure proposes a vehicle including a battery pack according to any of the above embodiments, wherein the battery management system module is adapted to send an alarm signal to a vehicle system of the vehicle when the vent of any of the battery cells bursts.

The battery module according to the embodiments of the present disclosure includes a thermal cable fixedly coupled to the circuit board, and a thermal circuit is formed inside the thermal cable and can provide a prompt signal indicating a bursting of a vent of any of the battery cells. The thermal cable is electrically connected to a BMS module. When no thermal runaway of any of the battery cells occurs and the battery cells operate normally, the thermal circuit formed inside the thermal cable has resistance or may be connected with a resistance in series, and a rated resistance of the thermal cable can be detected by the BMS module. When a thermal runaway of any of the battery cells occur, the corresponding vent bursts to heat the thermal cable, and the thermal cable can quickly sense a temperature change. When the temperature exceeds a predetermined threshold, the thermal circuit inside the thermal cable is short-circuited or open-circuited. A short-circuit signal or an open-circuit signal can be used as a prompt signal, and can accurately and effectively transmit an information that the thermal runaway of the battery cell occurs, to the outside, thereby improving the safety of the battery module in use.

In some optional embodiments, the thermal cable includes a wire forming the thermal circuit and an insulating layer surrounding an outer periphery of the wire. When a thermal runaway of any of the battery cells occurs, the corresponding vent bursts to heat the thermal cable. After a temperature of the thermal cable exceeds a predetermined threshold, the insulating layer is melted. As a result, some regions of the wire forming the thermal circuit are overlapped and connected, and thus a short circuit occurs. The short-circuit signal can be used as a prompt signal, and can accurately and effectively transmit an information that the thermal runaway of the battery cell occurs, to the outside.

### BRIEF DESCRIPTION OF THE DRAWINGS

Other features, advantages, and technical effects of the present disclosure will become more apparent by reading the following detailed description on non-limiting embodiments with reference to accompanying drawings, wherein the same or similar reference numerals indicate the same or similar features.
Fig. 1 is a perspective view showing a battery module according to an embodiment of the present disclosure;
Fig. 2 is an exploded perspective view of a battery module according to an embodiment of the present disclosure;
Fig. 3 is a perspective view of a battery module with a battery assembly and a cover plate removed according to an embodiment of the present disclosure;
Fig. 4 is an exploded perspective view of a battery module with a battery assembly and a cover plate removed according to an embodiment of the present disclosure;
Fig. 5 is a schematic structural view of a portion of a thermal cable according to an embodiment of the present disclosure;
Fig. 6 is a cross-sectional view taken along line A-A of Fig. 3;
Fig. 7 is a cross-sectional view taken along line B-B of Fig. 4;
Fig. 8 is a perspective view of a connecting member in a battery module according to an embodiment of the present disclosure;
Fig. 9 is a cross-sectional view taken along line C-C of Fig. 3;
Fig. 10 is a partially enlarged schematic view of portion D in Fig. 3;
Fig. 11 is a partially enlarged schematic view of portion E in Fig. 4.

In the accompanying drawings:
1-battery module;
11-battery assembly; 111-battery cell; 1111-vent; 1112-electrode;
12-circuit board; S1-first surface; S2-second surface; 121-body portion; 122-sampling terminal; 12h-hole;
13-thermal cable; 131-wire; 132-insulating layer; 139-electrical connector;
14-cover block; S5-fifth surface; 141-accommodating portion;
15-connecting member;
151-abutting portion; S3-third surface; S4-fourth surface; 151a-end portion; 1511-recess;
152-clamping portion; 1521-first protrusion; 1522-second protrusion; 1523-clamping space;
153-snap member; 1531-snap groove; S6-snap surface;
16-busbar;
17-cover plate; 171-cover connecting member;
X-first direction; Y-second direction;
L- distance from the snap surface to the second surface of the circuit board.

### DETAILED DESCRIPTION

Features of various aspects and specific embodiments of the present disclosure will be further described in detail below. In order to make technical objects, technical solutions and advantages of the present disclosure to be more apparent, the present disclosure is further described in detail with reference to the accompanying drawings and specific embodiments. It should be understood that, the specific embodiments described herein are only to be construed as illustrative and not limiting. To the person skilled in the art, the present disclosure may be practiced without some of the specific details. The following description of the embodiments is merely made to provide a better understanding of the present disclosure.

It should be noted that, in this context, terms such as "first" and "second" are used merely to distinguish one entity or operation from another entity or operation, and do not necessarily require or imply any actual relationship or order between the entities or operations. Further, terms "comprise", "include" or any other variations thereof are intended to encompass a non-exclusive inclusion, such that a process, method, article, or device including a plurality of elements, includes not only the plurality of elements, but also other elements not specifically listed, or other elements that are inherent to such a process, method, article, or device. The element that is defined by the phrase "includes......", without other limitations, does not exclude the presence of additional identical elements in the process, method, article, or device including this element.

It should be understood that when describing a configuration of a component, a layer or region being disposed "above" or "on" another layer or region, means that the layer or region is directly on another layer or region, or that there is other layer or region between the layer or region and another layer or region. Moreover, if the component is reversed, the layer or region will be located "below" or "under" another layer or region.

The embodiment of the present disclosure discloses a battery module and a battery pack, wherein the battery pack may include a battery module and a battery management system (BMS) module for managing the battery module and battery cells in the battery module, and detecting operation states of the battery module and the battery cells in the battery module.

Hereinafter, a battery module according to an embodiment of the present disclosure will be described in detail with reference to the accompanying drawings.

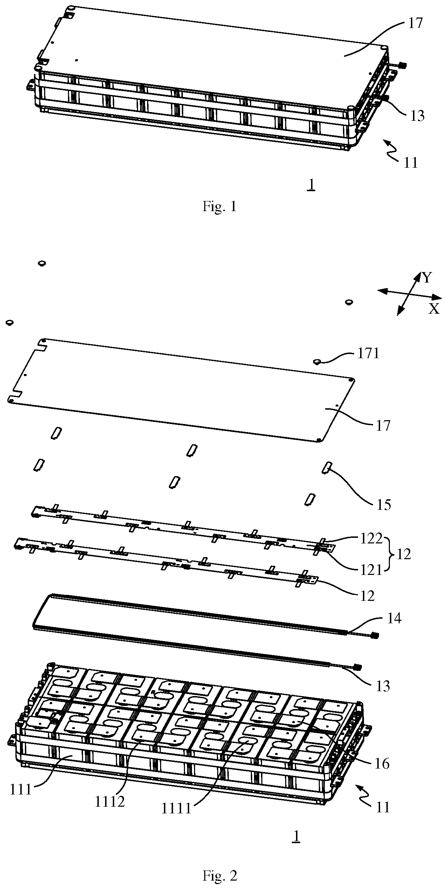

Fig. 1 and Fig. 2 respectively show a perspective view and an exploded perspective view of a battery module according to an embodiment of the present disclosure. The battery module 1 includes a battery assembly 11, a circuit board 12, etc.

The battery assembly 11 includes a plurality of battery cells 111 arranged in an array, and each of the battery cells 111 includes a vent 1111 and an electrode 1112. Each battery cell 111 may be a prismatic cell and includes a cap assembly, wherein the vent 1111 and the electrode 1112 may be disposed on the cap assembly. The plurality of battery cells 111 may be arranged in at least one row. In the present embodiment, the description is made by taking an example in which the plurality of battery cells 111 is arranged in two rows. In each row, a plurality of battery cells 111 are stacked in a thickness direction.

The circuit board 12 includes a body portion 121 and a plurality of sampling terminals 122, and the sampling terminals 122 are connected to the battery cells 111 and can collect electrical parameters and/or temperature parameters of the battery cells 111. In some embodiments, the circuit board 12 is a Flexible Printed Circuit (FPC). In some embodiments, the sampling terminals 122 may extend outward from the body portion 121 to facilitate connection with the battery cells 111. There may be one circuit board 12, or two or more circuit boards 12. In some embodiments, one circuit board 12 is disposed corresponding to each row of the battery cells 111 on a side thereof provided with the electrodes 1112.

The circuit board 12 may be electrically connected to the BMS module of the battery pack. For example, the circuit board 12 collects voltage signals and temperature signals of the battery cells 111, and transmits them to the BMS module.

In some embodiments, the sampling terminals 122 may be connected to the electrodes 1112 of the battery cells 111. Further, in some embodiments, the battery module 1 further includes a busbar 16 for connecting the electrodes 1112 of the battery cells 111, and the sampling terminals 122 of the circuit board 12 is connected to the battery cells 111 via the busbar 16.

In some embodiments, the battery module 1 may include a frame assembly to provide a space for accommodating the plurality of battery cells 111, and to provide protection for the accommodated battery cells 111 and other components. In the present embodiment, the battery module 1 includes a cover plate 17, which serves as at least a portion of the frame assembly on a side of the battery assembly 11 provided with the electrodes 1112.

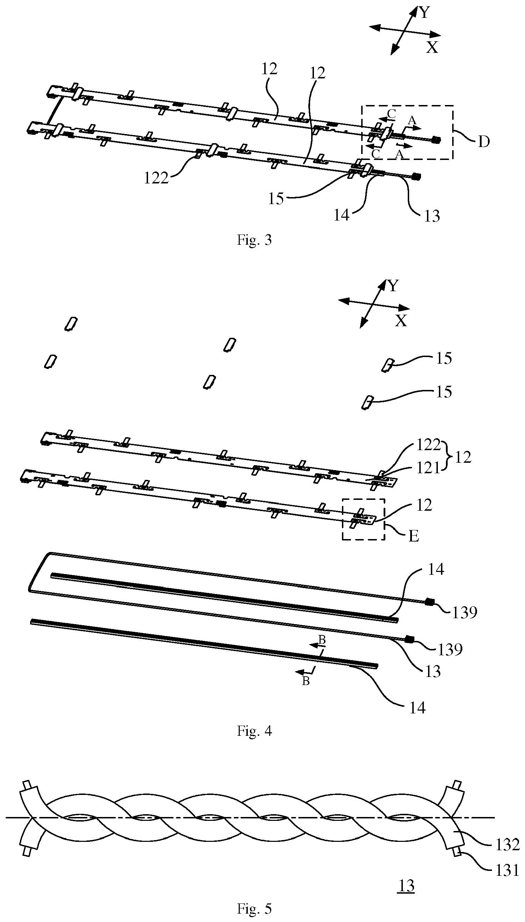

Fig. 3 and Fig. 4 are respectively a perspective view and an exploded perspective view of the battery module 1 with the battery assembly and the cover plate removed according to an embodiment of the present disclosure.

In the present embodiment, the battery module 1 further includes a thermal cable 13. The thermal cable 13 is located between the battery assembly 11 and the circuit board 12 and is fixedly coupled to the circuit board 12. Inside the thermal cable 13, a thermal circuit is formed, to provide a prompt signal indicating a bursting of the vent 1111 of any of battery cells 111.

During the use of the battery module 1, a thermal runaway of the battery cell 111 included therein may occur in some cases, and when the thermal runaway occurs, the vent 1111 of the corresponding battery cell 111 bursts. Herein, the bursting of the vent 1111 means that the vent 1111 is opened and a high-temperature gas, a high-temperature electrolyte or a spark is ejected when the thermal runaway of the battery cell 111 occurs, releasing a large amount of heat to an upper and peripheral space of the battery cell. By detecting whether or not the vent 1111 bursts, it can be known whether or not a thermal runaway of the corresponding battery cell 111 occurs.

According to the battery module 1 of the embodiment of the present disclosure, when a thermal runaway of any of the battery cells 111 occurs, the vent 1111 of the corresponding battery cell bursts to heat the thermal cable 13, and the thermal cable 13 can quickly sense a temperature change. When the temperature exceeds a predetermined threshold, the thermal circuit inside the thermal cable 13 is short-circuited or open-circuited. A short-circuit signal or an open-circuit signal can be used as a prompt signal, and can accurately and effectively transmit an information that the thermal runaway of the battery cell 111 occurs, to the outside, thereby improving safety of the battery module 1 in use.

In the battery pack including the battery module 1 according to the embodiment of the present disclosure, the thermal cable 13 may be electrically connected to the BMS module, that is, the thermal circuit formed inside the thermal cable 13 is electrically connected to the BMS module. When no thermal runaway of any of the battery cells 111 occurs and the battery cells 111 operate normally, the thermal circuit formed inside the thermal cable 13 has resistance or may be connected with a resistance in series, and a rated resistance of the thermal cable 13 may be detected by the BMS module. When a thermal runaway of any of the battery cells 111 occurs, the corresponding vent 1111 bursts to heat the thermal cable 13, and the thermal cable 13 can quickly sense a temperature change. When the temperature exceeds a predetermined threshold, the thermal circuit inside the thermal cable 13 is short-circuited or open-circuited. A short-circuit signal or an open-circuit signal may be transmitted to the BMS module as a prompt signal, and can accurately and effectively transmit an information that the thermal runaway of the battery cell 111 occurs, to the outside, thereby improving the safety of the battery module 1 in use.

In some embodiments, the battery module 1 and the battery pack are applied to a vehicle as a power source. When a thermal runaway of any of the battery cells 111 occurs, a prompt signal is provided by the thermal cable 13 and is transmitted to the BMS module, and the BMS module can quickly send an alarm signal to a vehicle system, thereby ensuring that the personnel in the vehicle have enough time to get away from the vehicle, avoiding the personnel in the vehicle from being damaged by the fire caused by the thermal runaway of the battery cell, and thus improving reliability and safety of the battery module 1 and the battery pack in the application.

In the present embodiment, the plurality of battery cells 111 in the battery module 1 are arranged in two rows, and the vents 1111 of each row of the battery cells 111 are arranged in line. In the present embodiment, the thermal cable 13 extends in a U-shape, and a projection of the thermal cable 13 on a plane where the vents 1111 of the plurality of battery cells 111 are located, passes through the vents 1111 of the plurality of battery cells 111. In some embodiments, the thermal cable 13 may be disposed immediately above the vents 1111 of the battery cells 111, so that the thermal cable 13 can be quickly heated and thus quickly provide the above-mentioned prompt signal, when the vent 111 of at least one of the battery cells 111 gets abnormal and bursts.

It can be understood that, in other embodiments, depending on the arrangement of the plurality of battery cells 111, the extending manner of the thermal cable 13 can be accordingly adjusted.

In the present embodiment, the thermal cable 13 extends in the U-shape, and may be provided with electrical connectors 139 at two ends. In some embodiments, the thermal circuit of the thermal cable 13 is electrically connected to the BMS module via the electrical connectors 139.

Fig. 5 shows a schematic structural view of a portion of the thermal cable according to an embodiment of the present disclosure, in which a segment of the thermal cable 13 is taken. The thermal cable 13 may be formed as a twisted-pair cable, and includes a wire 131 forming the thermal circuit and an insulating layer 132 surrounding an outer periphery of the wire 131. In some embodiments, at least one fixed resistor may be connected in series to the thermal circuit formed inside the thermal cable 13. In the present embodiment, the insulating layer 132 of the thermal cable 13 is melted when the vent 1111 of any of the battery cells 111 bursts so as to short-circuit the thermal circuit and thus provide a prompt signal.

Specifically, when a thermal runaway of any of the battery cells 111 occurs, the corresponding vent 1111 bursts to heat the thermal cable 13. After the temperature of the thermal cable 13 exceeds the predetermined threshold, the insulating layer 132 is melted. As a result, some regions of the wire 131 forming the thermal circuit are overlapped and connected, and thus a short circuit occurs. The short-circuit signal can be used as a prompt signal, and can accurately and effectively transmit an information that the thermal runaway of the battery cell occurs, to the outside (for example, BMS module).

As shown in Figs. 1 to 4, in some embodiments, the battery module 1 further includes a cover block 14. The cover block 14 extends in a first direction X, and is coupled to the circuit board 12. In some embodiments, the first direction X is parallel to a direction in which the battery cells 111 in each row are stacked.

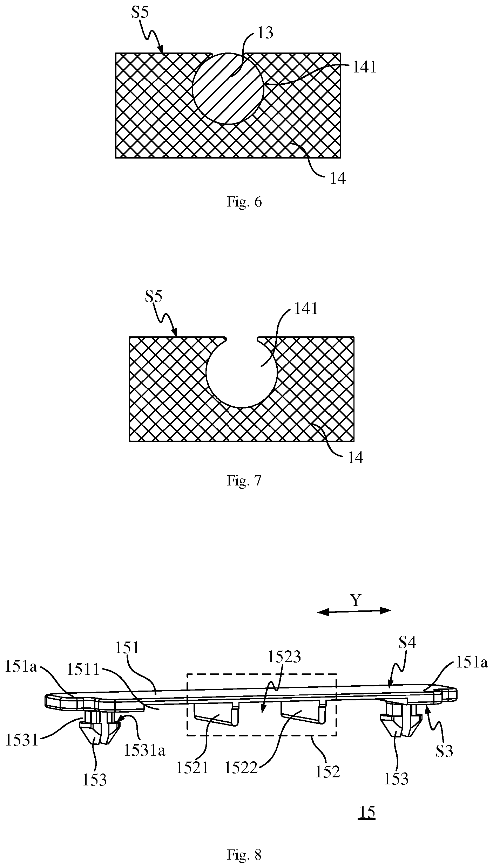

Fig. 6 is a cross-sectional view taken along line A-A of Fig. 3, and Fig. 7 is a cross-sectional view taken along line B-B of Fig. 4. The cover block 14 is provided with at least an accommodating portion 141 penetrating the cover block 14 in the first direction X, and the thermal cable 13 is at least partially accommodated in the accommodating portion 141. The cover block 14 is coupled to the circuit board 12 so as to achieve fixing and integration of the thermal cable 13 with the circuit board 12.

In some embodiments, the cover block 14 is an elastic block. For example, the cover block 14 is made of a foam material, and has a certain flexibility and elasticity. In the present embodiment, as an intermediate connecting member, the cover block 14 provides an assembling platform and space for the circuit board 12 and the thermal cable 13. Meanwhile, by means of the unique elasticity and flexibility of the cover block 14, the reliability of the components in all the operating conditions of the battery module can be ensured.

In some embodiments, the accommodating portion 141 may be formed as a passage in the cover block 14 extending in the first direction X, or may be formed as a through groove in the cover block 14 extending in the first direction X.

In the present embodiment, the accommodating portion 141 is formed as a channel extending in the first direction X. The cover block 14 has a fifth surface S5 facing the circuit board 12, and the channel is provided with an opening located at the fifth surface S5. Further, the channel has an inner wall surface in a shape matching with a shape of an outer peripheral surface of the thermal cable 13, so that the thermal cable 13 can be accommodated in the channel more stably. By forming the accommodating portion 141 as a channel with an opening, it is convenient to assemble and disassemble the thermal cable 13 with the cover block 14. The opening of the channel is located on the fifth surface S5 facing the circuit board 12, and thus can be closed after the cover block 14 is fixedly coupled to the circuit board 12, thereby avoiding a separation of the thermal cable 13 from the cover block 14 in use.

In some embodiments, the thermal cable 13 is interference-fitted with the accommodating portion 141 to achieve the fixing of the thermal cable 13 and satisfy the requirements on the thermal cable 13 under various operating conditions in a vibrating environment.

As shown in Figs. 1 to 4, in some embodiments, the battery module 1 further includes a connecting member 15. Fig. 8 shows a perspective view of a connecting member in a battery module 1 according to an embodiment of the present disclosure, wherein the connecting member 15 includes an abutting portion 151 and a clamping portion 152 that are connected to each other. In some embodiments, the connecting member 15 may be made of a plastic material.

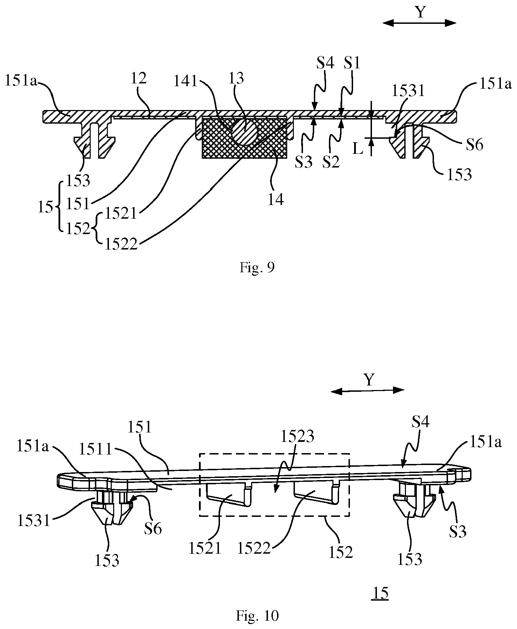

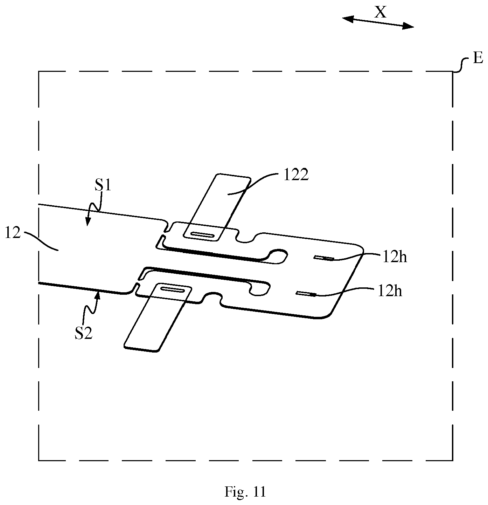

Fig. 9 is a schematic cross-sectional view taken along line C-C of Fig. 3. Fig. 10 is a partially enlarged schematic view of portion D in Fig. 3, in which a view angle in Fig. 10 is adjusted with respect to Fig. 3 to clearly show configurations of the components. Fig. 11 is a partially enlarged schematic view of portion E in Fig. 4.

In the present embodiment, the circuit board 12 includes a first surface S1 facing away from the battery assembly 11 and a second surface S2 facing the battery assembly 11. As shown in Fig. 11, the circuit board 12 is provided with a hole 12h penetrating the first surface S1 and the second surface S2. In some embodiments, a hole 12h is provided on the body portion 121.

In some embodiments, the abutting portion 151 of the connecting member 15 abuts against the first surface S1 of the circuit board 12, and the clamping portion 152 of the connecting member 15 passes through the hole 12h and clamps the cover block 14.

In some embodiments, the abutting portion 151 has a third surface S3 facing the circuit board 12, and the clamping portion 152 includes a first protrusion 1521 and a second protrusion 1522 that protrude from the third surface S3. The first protrusion 1521 and the second protrusion 1522 are spaced apart from each other with a clamping space 1523 formed between them, and the cover block 14 is located in the clamping space 1523. In some embodiments, when the cover block 14 is clamped in the clamping space 1523, the cover block 14 abuts against the second surface S2 of the circuit board 12.

In some embodiments, the abutting portion 151 has a fourth surface S4 facing away from the circuit board 12, and the connecting member 15 is provided with a recess 1511 on the third surface S3, which is recessed toward the fourth surface S4 of the abutting portion 151 and can accommodate a portion of the circuit board 12. By providing the recess 1511 to accommodate a portion of the circuit board 12, a thickness of a coupling assembly formed by the connecting member 15, the circuit board 12, the cover block 14 and the thermal cable 13 can be reduced, thereby increasing a space utilization rate within the battery module.

In some embodiments, the abutting portion 151 extends in a second direction Y, wherein the second direction Y intersects with the first direction X, and in some embodiments, the second direction Y may be perpendicular to the first direction X. The abutting portion 151 has two end portions 151a opposite to each other in the second direction Y. Each of the two end portions 151a is provided with a snap member 153 on the third surface S3, which can be coupled with the battery cell 111 and/or the busbar 16 in the battery module 1 in a snap fit manner.

In the battery module 1 according to the embodiment of the present disclosure, by means of the connecting member 15, the circuit board 12, the cover block 14 and the thermal cable 13 are coupled and the formed coupling assembly is fixedly coupled to the battery assembly 11 and/or the busbar 16 in a snap fit manner. As a result, there is no need to provide a wire harness isolation plate, an insulating sheet, etc., which can increase the space utilization rate, reduce a raw material cost of the circuit board 12, make the coupling assembly simpler and more convenient, and reduce assembly process of a factory line and the number of components, thereby effectively reducing a manufacturing cost.

In some embodiments, the snap member 153 includes a snap groove 1531 for engaging with the battery cell 111 and/or busbar 16 in a snap fit manner. The snap groove 1531 has a snap surface S6 abutting against the battery cell 111 and/or busbar 16. As shown in Fig. 9, in some embodiments, a distance L of the snap surface S6 to the second surface S2 of the circuit board 12 is smaller than a thickness of the cover block 14, wherein the thickness of the cover block 14 refers to a dimension of the cover block 14 in a direction perpendicular to the second surface S2. When the snap member 153 is engaged with the battery cell 111 and/or the busbar 16 in the snap fit manner, the cover block 14 is compressed in the thickness direction to a certain degree. Since the cover block 14 has elasticity, the snap-fit coupling of the connecting member 15, the circuit board 12, the cover block 14, the thermal cable 13 and the battery cell 111 and/or the busbar 16 is more stable and has better anti-vibration performance.

During an assembly of the above-described battery module 1, the thermal cable 13 can be assembled in the accommodating portion 141 of the cover block 14 in advance; then, the cover block 14 with the thermal cable 13 accommodated is disposed on the cap assemblies of the battery cells 111, and the circuit board 12 is correspondingly disposed on the cover block 14; and after that, the circuit board 12 and the cover block 14 are fixed to the battery cells 111 and/or the busbars 16 by the connecting member 15. Wherein, the abutting portion 151 of the connecting member 15 abuts against the first surface S1 of the circuit board 12, and the clamping portion 152 of the connecting member 15 passes through the holes 12h and clamps the cover block 14, thereby realizing the fixing of the connecting member 15, the circuit board 12, the cover block 14 and the thermal cable 13; and the connecting member 15 is engaged with the battery cell 111 and/or the busbar 16 via the snap member 153 in a snap fit manner, thereby realizing the fixing of the connecting member 15, the circuit board 12, the cover block 14 and the thermal cable 13 to the battery cells 111. Thereafter, the cover plate 17 can be assembled on the circuit board 12, and the cover plate 17 is fixedly coupled to the battery assembly 11 by a cover connecting member 171, thereby realizing assembly of the battery module 1.

In the above embodiments of the present disclosure, not all the details are described, and the present disclosure are not limited to the described specific embodiments. Obviously, many modifications and variations are possible in light of the above description. The above embodiments has been selected and described in detail to better explain the principles and practical applications of the present disclosure, so that the person skilled in the art can make a good use of the present disclosure and make modifications based on the present disclosure. The invention is defined by the appended claims.

## Claims

1. A battery module (1), comprising:
a battery assembly (11), comprising a plurality of battery cells (111) arranged in an array, wherein each of the battery cells (111) comprises a vent (1111);
a circuit board (12), comprising a plurality of sampling terminals (122) connected to the battery cells (111) and being capable of collecting electrical parameters and/or temperature parameters of the battery cells (111); and
a thermal cable (13), located between the battery assembly (11) and the circuit board (12) and fixedly coupled to the circuit board (12), wherein a thermal circuit is formed inside the thermal cable (13), and the thermal circuit is configured to provide a prompt signal indicating a bursting of the vent (1111) of any of the battery cells (111),
**characterized in that**,
the battery module further comprises a cover block (14), extending in a first direction (X) and provided with at least an accommodating portion (141) penetrating the cover block (14) in the first direction (X), wherein the thermal cable (13) is at least partially accommodated in the accommodating portion (141), and the cover block (14) is coupled to the circuit board (12).

2. The battery module (1) according to claim 1, **characterized in that**, the thermal cable (13) comprises a wire (131) forming the thermal circuit and an insulating layer (132) surrounding an outer periphery of the wire (131), and the insulating layer (132) of the thermal cable (13) is melted when the vent (1111) of any of the battery cells (111) bursts, so as to short-circuit the thermal circuit and provide the prompt signal.

3. The battery module (1) according to claim 1, **characterized in that**, further comprising:
a connecting member (15), comprising an abutting portion (151) and a clamping portion (152) connected with each other; and
the circuit board (12) comprises a first surface (S1) facing away from the battery assembly (11) and a second surface (S2) facing the battery assembly (11), and the circuit board (12) is provided with a hole (12h) penetrating the first surface (S1) and the second surface (S2), wherein the abutting portion (151) is configured to abut against the first surface (S1), and the clamping portion (152) is configured to pass through the hole (12h) and clamp the cover block (14).

4. The battery module (1) according to claim 3, **characterized in that**, the abutting portion (151) comprises a third surface (S3) facing the circuit board (12), and the clamping portion (152) comprises a first protrusion (1521) and a second protrusion (1522) protruding from the third surface (S3), wherein the first protrusion (1521) and the second protrusion (1522) are spaced apart from each other with a clamping space (1523) formed between them, and the cover block (14) is located in the clamping space (1523); and
the cover block (14) is configured to abut against the second surface (S2) of the circuit board (12).

5. The battery module (1) according to claim 4, **characterized in that**, the abutting portion (151) has a fourth surface (S4) facing away from the circuit board (12), and is provided with a recess (1511) on the third surface (S3), wherein the recess (1511) is recessed toward the fourth surface (S4) of the abutting portion (151) and is capable of accommodating a portion of the circuit board (12).

6. The battery module (1) according to claim 4 or claim 5, **characterized in that**, each of the battery cells (111) comprises an electrode (1112), and
the battery module (1) further comprises:
a busbar (16) for connecting the electrodes (1112) of the battery cells (111), and the sampling terminals (122) of the circuit board (12) are connected to the battery cells (111) via the busbar (16); and
the abutting portion (151) is configured to extend in a second direction (Y), which intersects with the first direction (X), and has two end portions (151a) opposite to each other in the second direction (Y), wherein each of the two end portions (151a) is provided with a snap member (153) on the third surface (S3), and the snap member (153) can be coupled to the battery cell (111) and/or the busbar (16) in a snap fit manner.

7. The battery module (1) according to claim 6, **characterized in that**, the snap member (153) comprises a snap groove, which is engaged with the battery cell (111) and/or the busbar (16) in a snap fit manner and comprises a snap surface abutting against the battery cell (111) and/or the busbar (16), wherein a distance of the snap surface (S6) to the second surface (S2) of the circuit board (12) is smaller than a thickness of the cover block (14).

8. The battery module (1) according to any of claims 1-7, **characterized in that**, the accommodating portion (141) is formed as a channel extending in the first direction (X), and the cover block (14) has a fifth surface (S5) facing the circuit board (12), wherein the channel is provided with an opening located at the fifth surface (S5) and has an inner wall surface in a shape matching with a shape of an outer peripheral surface of the thermal cable (13).

9. The battery module (1) according to any of claims 1 to 8, **characterized in that**, the thermal cable (13) is interference-fitted with the accommodating portion (141).

10. The battery module (1) according to any of claims 1 to 9, **characterized in that**, the cover block (14) is formed as an elastic block.

11. The battery module (1) according to any of claims 1 to 10, **characterized in that**, the thermal cable (13) has a projection passing through the vents (1111) of the plurality of battery cells (111), on a plane where the vents (1111) of the plurality of battery cells (111) are located.

12. A battery pack, **characterized in that**, comprising:
a battery module (1) according to any of claims 1 to 11; and
a battery management system module, wherein the thermal cable (13) of the battery module (1) is electrically connected to the battery management system module.

13. A vehicle, **characterized in that**, comprising a battery pack according to claim 12, wherein the battery management system module is adapted to send an alarm signal to a vehicle system of the vehicle when the vent (1111) of any of the battery cells (111) bursts.

## Patentansprüche

1. Batteriemodul (1), umfassend:
ein Batterieset (11), das eine Vielzahl von Batteriezellen (111) umfasst, die in einem Array angeordnet sind, wobei jede der Batteriezellen (111) eine Entlüftung (1111) umfasst;
eine Leiterplatte (12), die eine Vielzahl von Abtastanschlüssen (122) umfasst, die mit den Batteriezellen (111) verbunden sind und in der Lage sind, elektrische Parameter und/oder Temperaturparameter der Batteriezellen (111) zu sammeln; und
ein Thermokabel (13), das sich zwischen dem Batterieset (11) und der Leiterplatte (12) befindet und fest mit der Leiterplatte (12) verbunden ist, wobei ein Thermokreislauf innerhalb des Thermokabels (13) gebildet ist, und der Thermokreislauf dazu eingerichtet ist, ein Meldesignal, das die Explosion der Entlüftung (1111) einer der Batteriezellen (111) anzeigt,
**dadurch gekennzeichnet, dass**
das Batteriemodul ferner einen Abdeckblock (14) umfasst, der sich in einer ersten Richtung (X) erstreckt und mit mindestens einem Aufnahmeabschnitt (141) versehen ist, der den Abdeckblock (14) in der ersten Richtung (X) durchdringt, wobei das Thermokabel (13) zumindest teilweise in dem Aufnahmeabschnitt (141) aufgenommen ist und der Abdeckblock (14) mit der Leiterplatte (12) gekoppelt ist.

2. Batteriemodul (1) nach Anspruch 1, **dadurch gekennzeichnet, dass** das Thermokabel (13) einen Draht (131), der den Thermokreislauf bildet, und eine Isolierschicht (132), die einen Außenumfang des Drahts (131) umgibt, umfasst, und die Isolierschicht (132) des Thermokabels (13) schmilzt, wenn die Entlüftung (1111) einer der Batteriezellen (111) explodiert, so dass Kurzschluss des Thermokreislaufs auftritt und das Meldesignal bereitgestellt wird.

3. Batteriemodul (1) nach Anspruch 1, **dadurch gekennzeichnet, dass** ferner Folgendes umfasst:
ein Verbindungselement (15), das einen Anlageabschnitt (151) und einen Klemmabschnitt (152) umfasst, die miteinander verbunden sind; und
die Leiterplatte (12), die eine dem Batterieset (11) abgewandte erste Oberfläche (S1) und eine dem Batterieset (11) zugewandte zweite Oberfläche (S2) umfasst und die Leiterplatte (12) mit einem Loch (12h) versehen ist, das die erste Oberfläche (S1) und die zweite Oberfläche (S2) durchdringt, wobei der Anlageabschnitt (151) so eingerichtet ist, dass er an der ersten Oberfläche (S1) anliegt, und der Klemmabschnitt (152) dazu eingerichtet ist, durch das Loch (12h) durchzudringen und den Abdeckblock (14) zu klemmen.

4. Batteriemodul (1) nach Anspruch 3, **dadurch gekennzeichnet, dass** der Anlageabschnitt (151) eine der Leiterplatte (12) zugewandte dritte Fläche (S3) umfasst und der Klemmabschnitt (152) einen ersten Vorsprung (1521) und einen zweiten Vorsprung (1522), die von der dritten Fläche (S3) vorstehen, umfasst, wobei der erste Vorsprung (1521) und der zweite Vorsprung (1522) durch einen zwischen ihnen gebildeten Klemmraum (1523) voneinander beabstandet sind, und sich der Abdeckblock (14) im Klemmraum (1523) befindet; und
der Abdeckblock (14) so eingerichtet ist, dass er an der zweiten Oberfläche (S2) der Leiterplatte (12) anliegt.

5. Batteriemodul (1) nach Anspruch 4, **dadurch gekennzeichnet, dass** der Anlageabschnitt (151) eine der Leiterplatte (12) abgewandte vierte Fläche (S4) aufweist und mit einer Vertiefung (1511) auf der dritten Fläche (S3) versehen ist, wobei die Vertiefung (1511) in Richtung der vierten Fläche (S4) des Anlageabschnitts (151) vertieft ist und in der Lage ist, einen Abschnitt der Leiterplatte (12) aufzunehmen.

6. Batteriemodul (1) nach Anspruch 4 oder Anspruch 5, **dadurch gekennzeichnet, dass** jede der Batteriezellen (111) eine Elektrode (1112) umfasst, und
das Batteriemodul (1) ferner umfasst:
eine Sammelschiene (16) zum Verbinden der Elektroden (1112) der Batteriezellen (111), und die Abtastanschlüsse (122) der Leiterplatte (12) mit den Batteriezellen (111) über die Sammelschiene (16) verbunden sind; und
der Anlageabschnitt (151) so eingerichtet ist, dass er sich in einer zweiten Richtung (Y) erstreckt, die die erste Richtung (X) schneidet, und zwei Endabschnitte (151a) aufweist, die in der zweiten Richtung (Y) einander gegenüberliegend sind, wobei jeder der beiden Endabschnitte (151a) mit einem Schnappelement (153) an der dritten Oberfläche (S3) versehen ist und das Schnappelement (153) mit der Batteriezelle (111) und/oder der Sammelschiene (16) über eine Schnappverbindung koppelbar ist.

7. Batteriemodul (1) nach Anspruch 6, **dadurch gekennzeichnet, dass** das Schnappelement (153) eine Schnappnut umfasst, die mit der Batteriezelle (111) und/oder der Sammelschiene (16) über eine Schnappverbindung in Eingriff steht und eine an der Batteriezelle (111) und/oder der Sammelschiene (16) anliegende Schnappfläche aufweist, wobei ein Abstand von der Schnappfläche (S6) zur zweiten Fläche (S2) der Leiterplatte (12) kleiner als eine Dicke des Abdeckblocks (14) ist.

8. Batteriemodul (1) nach einem der Ansprüche 1-7, **dadurch gekennzeichnet, dass** der Aufnahmeabschnitt (141) als sich in der ersten Richtung (X) erstreckender Kanal ausgebildet ist und der Abdeckblock (14) a fünfte Fläche (S5) aufweist, die der Leiterplatte (12) zugewandt ist, wobei der Kanal mit einer Öffnung versehen ist, die sich an der fünften Fläche (S5) befindet, und eine Innenwandfläche durch Formschluss mit einer Form einer Außenumfangsfläche des Thermokabels (13) aufweist.

9. Batteriemodul (1) nach einem der Ansprüche 1 bis 8, **dadurch gekennzeichnet, dass** das Thermokabel (13) mit dem Aufnahmeabschnitt (141) mit Presspassung verbunden ist.

10. Batteriemodul (1) nach einem der Ansprüche 1 bis 9, **dadurch gekennzeichnet, dass** der Abdeckblock (14) als elastischer Block ausgebildet ist.

11. Batteriemodul (1) nach einem der Ansprüche 1 bis 10, **dadurch gekennzeichnet, dass** das Thermokabel (13) eine Projektion aufweist, die durch die Entlüftungen (1111) der Vielzahl von Batteriezellen (111) auf einer Ebene der Entlüftungen (1111) der Vielzahl von Batteriezellen (111) durchdringt.

12. Batteriepack, **dadurch gekennzeichnet, dass** es umfasst:
ein Batteriemodul (1) nach einem der Ansprüche 1 bis 11; und
ein Batteriemanagementsystemmodul, wobei das Thermokabel (13) des Batteriemoduls (1) mit dem Batteriemanagementsystemmodul elektrisch verbunden ist.

13. Fahrzeug, **dadurch gekennzeichnet, dass** es ein Batterieset nach Anspruch 12 umfasst, wobei das Batteriemanagementsystemmodul dazu eingerichtet ist, ein Alarmsignal an ein Fahrzeugsystem des Fahrzeugs zu senden, wenn die Entlüftung (1111) einer der Batteriezellen (111) explodiert.

## Revendications

1. Module de batterie (1) comprenant :
un ensemble de batteries (11), comprenant une pluralité de cellules de batterie (111) agencées en matrice, chacun des cellules de batterie (111) comprenant un évent (1111) ;
une carte de circuit imprimé (12), comprenant une pluralité de bornes d'échantillonnage (122) connectées aux cellules de batterie (111) et étant capable de collecter des paramètres électriques et/ou des paramètres de température des cellules de batterie (111) ; et
un câble thermique (13), agencé entre l'ensemble de batteries (11) et la carte de circuit imprimé (12) et couplé de manière fixe à la carte de circuit imprimé (12), un circuit thermique étant formé à l'intérieur du câble thermique (13), et le câble thermique le circuit étant configuré pour fournir un signal indicatif indiquant un éclatement de l'évent (1111) de l'une quelconque des cellules de batterie (111),
**caractérisé en ce que**,
le module de batterie comprend en outre un bloc de couvercle (14) s'étendant dans une première direction (X) et pourvu d'au moins une part de réception (141) pénétrant dans le bloc de couvercle (14) dans la première direction (X), le câble thermique (13) étant au moins en partie reçu dans la part de réception (141), et le bloc de couvercle (14) étant couplé à la carte de circuit imprimé (12).

2. Module de batterie (1) selon la revendication 1, **caractérisé en ce que** le câble thermique (13) comprend un fil (131) formant le circuit thermique et une couche isolante (132) entourant une périphérie externe du fil (131), et la couche isolante (132) du câble thermique (13) fondra lorsque l'évent (1111) de l'une quelconque des cellules de batterie (111) s'éclate, mettant ainsi le circuit thermique à court-circuit et fournissant le signal indicatif.

3. Module de batterie (1) selon la revendication 1, **caractérisé en ce qu'**il comprend en outre :
un élément de connexion (15), comprenant une part d'appui (151) et une part de pinçage (152) connectées l'une à l'autre ; et
la carte de circuit imprimé (12) comprend une première surface (S 1) à l'opposé de l'ensemble de batteries (11) et une deuxième surface (S2) en face à l'ensemble de batteries (11), la carte de circuit imprimé (12) étant pourvue d'un trou (12h) pénétrant dans la première surface (S1) et la deuxième surface (S2), la part d'appui (151) étant configurée pour s'appuyer contre la première surface (S1), et la part de pinçage (152) étant configurée pour passer à travers le trou (12h) et pincer le bloc de couvercle (14).

4. Module de batterie (1) selon la revendication 3, **caractérisé en ce que** la part d'appui (151) comprend une troisième surface (S3) en face à la carte de circuit imprimé (12), et la part de pinçage (152) comprend une première saillie (1521) et une deuxième saillie (1522) en saille de la troisième surface (S3), la première saillie (1521) et la deuxième saillie (1522) étant disposées à l'intervalle avec un espace de pinçage (1523) formé entre elles, et le bloc de couvercle (14) étant disposé dans l'espace de pinçage (1523) ; et
le bloc de couvercle (14) est configuré pour s'appuyer contre la deuxième surface (S2) de la carte de circuit imprimé (12).

5. Module de batterie (1) selon la revendication 4, **caractérisé en ce que** la part d'appui (151) comprend une quatrième surface (S4) à l'opposé de la carte de circuit imprimé (12), et est pourvue d'un évidement (1511) sur la troisième surface (S3), l'évidement (1511) se creusant vers la quatrième surface (S4) de la part d'appui (151) et étant capable de recevoir une part de la carte de circuit imprimé (12).

6. Module de batterie (1) selon la revendication 4 ou 5, **caractérisé en ce que** chacune des cellules de batterie (111) comprend une électrode (1112), et
le module de batterie (1) comprend en outre :
un bus (16) connecté aux électrodes (1112) des cellules de batterie (111), les bornes d'échantillonnage (122) de la carte de circuit imprimé (12) étant connectées aux cellules de batterie (111) via le bus (16) ; et
la part d'appui (151) étant configurée pour s'étendre dans une deuxième direction (Y), qui coupe la première direction (X), dont deux parts d'extrémité (151a) sont en opposés dans la deuxième direction (Y), chacune des deux parts d'extrémité (151a) étant pourvue d'un élément d'encliquetage (153) sur la troisième surface (S3), et l'élément d'encliquetage (153) étant capable de couplé à la cellule de batterie (111) et/ou au bus (16) par encliquetage.

7. Module de batterie (1) selon la revendication 6, **caractérisé en ce que** l'élément d'encliquetage (153) comprend une rainure d'encliquetage, qui est engrené avec la cellule de batterie (111) et/ou le bus (16) par encliquetage et comprend une surface d'encliquetage s'appuyant contre la cellule de batterie (111) et/ou le bus (16), une distance entre la surface d'encliquetage (S6) et la deuxième surface (S2) de la carte de circuit imprimé (12) étant inférieure à une épaisseur du bloc de couvercle (14).

8. Module de batterie (1) selon l'une quelconque des revendications 1 à 7, **caractérisé en ce que** la part de réception (141) est formée en canal s'étendant dans la première direction (X), et le bloc de couvercle (14) comprend une cinquième surface (S5) en face à la carte de circuit imprimé (12), le canal étant pourvu d'une ouverture sur la cinquième surface (S5) et comprenant une surface de la paroi interne en forme correspondant à une forme d'une surface périphérique externe du câble thermique (13).

9. Module de batterie (1) selon l'une quelconque des revendications 1 à 8, **caractérisé en ce que** le câble thermique (13) est ajusté sans jeu avec la part de réception (141).

10. Module de batterie (1) selon l'une quelconque des revendications 1 à 9, **caractérisé en ce que** le bloc de couvercle (14) est un bloc élastique.

11. Module de batterie (1) selon l'une quelconque des revendications 1 à 10, **caractérisé en ce que** le câble thermique (13) présente une projection passant à travers les évents (1111) de la pluralité de cellules de batterie (111), sur un plan dans lequel sont situées les évents (1111) de la pluralité de cellules de batterie (111).

12. Bloc de batteries, **caractérisé en ce qu'**il comprend :
un module de batterie (1) selon l'une quelconque des revendications 1 à 11 ; et
un module de système de gestion de batteries, le câble thermique (13) du module de batterie (1) étant connecté électriquement au module de système de gestion de batteries.

13. Véhicule, **caractérisé en ce qu'**il comprend un bloc de batteries selon la revendication 12, le module de système de gestion de batteries étant adapté pour envoyer un signal d'alarme à un système de véhicule du véhicule lorsque l'évent (1111) de l'une quelconque des cellules de batterie (111) s'éclate.
